# EUROPEAN PATENT APPLICATION

(11) **EP 1 548 147 A1**
(43) Date of publication of application: **29.06.2005**
(21) Application number: 04030291.1
(22) Date of filing: 21.12.2004
(51) Int. Cl.: C23C 14/04, C23C 4/12

(54) **Thin film formation method**

(30) Priority: 26.12.2003 JP 2003431921; 21.12.2004 JP 2004368619
(71) Applicant: SEIKO EPSON CORPORATION, Shinjuku-ku, Tokyo 163-0811 (JP)
(72) Inventor: Yotsuya, Shinichi, Suwa-shi, Nagano-ken 392-8502 (JP)
(74) Representative: HOFFMANN - EITLE

(57) **Abstract**

The invention relates to providing a thin film formation method which can carry out various kinds of patterning deposition such as a mask vapor deposition with high precision and correctly, and a thin film formation equipment, and furthermore, to provide a method of manufacturing an organic electroluminescence device using the thin film formation method, an organic electroluminescence device, and an electronic apparatus having the organic electroluminescence device. A thin film formation method that arranges a mask M between a substrate G and a material source 1 and forms the material of the material source 1 as thin film in the substrate G, comprises: a substrate contacting process to contact the mask M and the substrate G; a gap measurement process to measure a gap between the mask M and the substrate G; and a thin film formation process to form the thin film according to the measurement result in the gap measurement process.

## Description

### [Field of the Invention]

The present invention relates to a thin film formation method, thin film formation equipment, a method of manufacturing an organic electroluminescence device, an organic electroluminescence device, and an electronic apparatus.

### [Description of the Related Art]

Because an organic electroluminescence (hereinafter, referred to as organic EL) device is a self-luminescence type, high-speed response display device that has a structure of depositing thin films, a display panel which is light-weighted and excellent in dealing with moving-pictures can be formed. Therefore, in recent years, much attention has been paid to the organic EL as a display panel, such as FPD (Flat Panel Display) television. As for the typical manufacturing method thereof, it is known a method of patterning a transparent anode, such as ITO (indium-tin oxide) to a desired shape by using a photolithographic technology, furthermore multilayer-forming the organic material with resistor heating type vacuum vapor deposition equipment, and then forming a cathode. Here, the cathode is formed by vapor depositing a metal anode film such as MgAg with a low work function, and furthermore a light emitting element is sealed in an inactive gas atmosphere and thereby is protected against moisture, oxygen, and the like.

Furthermore, because a luminescence color is changed in many ways by changing the luminescence material, a very clear full color organic EL device can be manufactured by forming the light emitting elements of red, green, and blue for every pixel, by mask vapor deposition, respectively. In the method of manufacturing such a full color organic EL device, a full color organic EL device is manufactured by covering a desired vapor deposition portion with a thin and high definition metal mask, which is larger than the panel size, and by carrying out a highly precise selective vapor deposition for each color, with the metal mask being attracted with a certain specific magnet from the back face of a glass substrate (for example, refer to Patent Document 1).

### [Patent Document 1]

Japanese Unexamined Patent Publication No. 2002-75638

### [Disclosure of the Invention]

### [Problem to be Solved]

However, because the thermal expansion coefficient of the metal mask is very large compared with the glass substrate for the panel, the metal mask expands larger than the glass substrate for the panel by radiation heat effect at the time of the vapor deposition as the panel size becomes large, which causes stress, and lifting due to this stress occurs in a portion which a magnet is attracting. Thereby, there is a problem that a highly precise and exact vapor deposition cannot be carried out. For example, defects such as that the material mixes in the other color pixels frequently, and a problem of very poor yield occurs.

The present invention has been made in view of the above described problem, and is intended to provide a thin film formation method and a thin film formation equipment which allow to carry out various kinds of patterning deposition, such as a mask vapor deposition with high precision and correctly, and further to provide a method of manufacturing an organic electroluminescence device using the thin film formation method, an organic electroluminescence device, and an electronic apparatus provided with the organic electroluminescence device.

### [Means to Solve the Problem]

In order to attain the above described objective, the present invention adopts the following structures. A thin film formation method according to the present invention that arranges a mask between a substrate and a material source and forms material of the material source as thin film in the substrate, comprises: a substrate contacting process to contact the mask and the substrate; a gap measurement process to measure a gap between the mask and the substrate; and a thin film formation process to form the thin film according to the measurement result on the gap measurement process. Here, "the thin film formation process to form the thin film according to the measurement result" means carrying out various kinds of controls of the thin film formation process based on the measurement result. For example, provision is made to form the thin film in a desired condition by changing thin film formation conditions.

If doing this way, the mask and the substrate can be contacted by carrying out the substrate contacting process. Furthermore, because the gap between the mask and the substrate in contact condition is measured by carrying out the gap measurement process, mask lifting due to the thermal expansion can be detected. Furthermore, by carrying out the thin film formation process according to the measurement result of the gap measurement process, the gap occurrence can be prevented, and the thin film can be formed in the substrate with the mask and the substrate being contacted. By going through such a series of processes, the thin film of a predetermined pattern according to the mask openings can be formed to the substrate with high precision and correctly. Accordingly, occurrence of defects such as that the material mixes in the other color pixels, which is a conventional problem, can be suppressed, therefore the yield improvement can be attained.

Moreover, in the thin film formation method, the gap measurement process is carried out before the thin film formation process. If doing this way, the thin film formation process will be carried out according to the measurement result of the gap measurement process after having carried out the gap measurement process, therefore the thin film formation can be carried out while being suitably contacted. Moreover, the thin film formation can be carried out after having checked the contact condition of the mask and the substrate.

Moreover, in the thin film formation method, the gap measurement process is carried out simultaneously with the thin film formation process. If doing this way, the thin film formation process is carried out according to the measurement result of the gap measurement process while carrying out the gap measurement process, therefore the gap is measured while the thin film is being formed, and the thin film formation process can be carried out according to the measurement result.

Moreover, in the thin film formation method, the thin film formation process is stopped according to the measurement result of the gap measurement process. If doing this way, for example, in case that the measurement result of the gap measurement process shows abnormalities (the gap has been enlarged), the thin film formation process is stopped, and therefore the thin film will not be formed with the gap being large. Accordingly, the occurrence of defects such as that material mixes into the other color pixels can be prevented in advance.

Moreover, in the thin film formation method, the contact force in the substrate contacting process is changed according to the measurement result of the gap measurement process. If doing this way, the contact force of the mask and the substrate changes according to the gap size, therefore, for example, in case that the gap becomes large, the gap can be made small by increasing the contact force of the mask and the substrate.

Moreover, in the thin film formation method, the substrate contacting process contacts the substrate and the mask with a magnetic force. Here, as for the one that generates a magnetic force, an electromagnet or an electromagnet is employed. In case that an electromagnet is used, the magnetic force can be controlled by controlling the amount of electric current. Moreover, in case that a magnet is used, electric-current supply will be unneeded, and it is possible to attract with a predetermined magnetic force. If doing this way, because the mask is attracted to the substrate side by the magnetic force, the both can be contacted suitably.

Moreover, in the thin film formation method, the substrate contacting process presses and contacts the substrate to the mask. Here, pressing the mask to the substrate is carried out by adding a load to the substrate using a predetermined weight or adding a load to the substrate using an elastic body, such as a spring. If doing this way, the both can be contacted by pressing the substrate to the mask.

Moreover, in the thin film formation method, the substrate contacting process contacts the substrate and the mask with an electrostatic force. Here, contacting the mask and the substrate with an electrostatic force is carried out by applying potentials of different polarity, plus (+) and (-), to each of the mask and the substrate. If doing this way, the both can be contacted using the electrostatic force that occurs between the mask and the substrate.

Moreover, in the thin film formation method, the gap measurement process uses a laser beam. Here, using a laser beam means that a laser beam is irradiated to a plurality of measurement objects, and the distances between the plurality of measurement objects are measured by measuring the intensity of the laser beam reflected by each of the plurality of measurement objects. If doing this way, because the changes of the laser beam intensity can be measured as the amount of gap between the mask and the substrate, the gap can be measured easily. Moreover, the measurement is optically carried out not contacting to the measurement object, the measurement object will be neither damaged nor destroyed.

Moreover, in the thin film formation method, the gap measurement process is carried out by measuring an electrostatic capacitance. If doing this way, because the electrostatic capacitance can be measured as the amount of gap between the mask and the substrate, the gap can be measured easily. Moreover, because the measurement is electrically carried out not contacting to the measurement object, the measurement object will be neither damaged nor destroyed.

Moreover, in the thin film formation method, the gap measurement process is carried out from non-formation face side of the thin film in the substrate. If doing this way, because the material of the material source will not adhere to the gap measurement means, occurrence of the measurement error due to the material adhering to the gap measurement means can be prevented. Accordingly, the gap between the mask and the substrate can be measured suitably.

Moreover, in the thin film formation method, the gap measurement process measures the gap at least either near the comer portion or in the center portion within the main face of the substrate. Here, portions near the comer portion and in the center portion within the main face of the substrate are where the gap between the mask and the substrate will easily occur. Accordingly, the gap in the portions where the gap will easily occur can be measured by measuring the portions near the comer portion and in the center portion.

Moreover, a thin film formation equipment according to the present invention that arranges a mask between a substrate and a material source and forms the material of the material source as thin film in the substrate, comprises: a substrate contacting means to contact the mask and the substrate; a gap measurement means to measure a gap between the mask and the substrate; and a thin film formation means to form thin film in the substrate. If doing this way, the mask and the substrate can be contacted by having the substrate contacting means. Furthermore, because the gap between the mask and the substrate, which are in contact condition, can be measured by having the gap measurement means, lifting and peeling of the mask resulting from the thermal expansion can be detected. Furthermore, by carrying out the thin film formation process according to the measurement result of the gap measurement means, the gap occurrence can be prevented, and the thin film can be formed in the substrate with the mask and the substrate being contacted. By having such means, the thin film of a predetermined pattern according to the mask openings can be formed to the substrate with high precision and correctly. Accordingly, because the occurrence of defects such as that the material mixes in the other color pixels, which is the conventional problem, can be suppressed, the yield improvement can be attained.

Moreover, in the thin film formation equipment, there is further provided with a displacement means to displace the gap measurement means in the direction parallel to the substrate. If doing this way, the gap measurement means can be arranged in an arbitrary position on the substrate face. Accordingly, the gap between the mask and the substrate in an arbitrary position can be measured.

Moreover, in the thin film formation equipment, there is further provided with a control means to control at least any one of the substrate contacting means, the gap measurement means, the thin film formation means, and the displacement means. Here, the control means has a function to control the entire of the thin film formation equipment. Accordingly, the control means can control the thin film formation process according to the measurement result of the gap measurement means. Moreover, the control means can change the contact force of the substrate contacting means. Moreover, the control means can control the displacement means.

Moreover, a method of manufacturing an organic EL device according to the present invention is the method of manufacturing an organic EL device that is formed by adhering each of a plurality of different material to the substrate in a predetermined pattern, wherein the above described thin film formation method is used. If doing this way, thin film made of each of a plurality of different material can be formed in a predetermined pattern, in the substrate. Moreover, the predetermined pattern can be formed with high precision and correctly. Accordingly, the occurrence of the defects such as that the material mixes in the other color pixels, which is the conventional problem, can be suppressed, therefore the yield improvement can be attained. Then, color mixing into pixels can be prevented.

Moreover, an organic EL device according to the present invention is manufactured by using the above described manufacturing method. If doing this way, an organic EL device having pixels without color mixing and enabling clear picture displaying will be made.

Moreover, an electronic apparatus according to the present invention is provided with the above described organic EL device. Here, as for the electronic apparatus, for example, a cellular-phone, a mobile information terminal, a clock, a word processor, and an information processing apparatus, such as a personal computer can be exemplified. Accordingly, according to the present invention, because there is provided with a display portion using the above described organic EL device, an electronic apparatus provided with a display portion, which has pixels without color mixing and enables clear picture displaying, will be made.

### [Brief Description of the Drawings]

FIG. 1 is a cross-sectional side view showing the outline structure of a mask vapor deposition equipment of one embodiment of the present invention.
FIG. 2 is a cross-sectional side view showing the principal part configuration in the mask vapor deposition equipment of one embodiment of the present invention.
FIG. 3 is a flow chart of the mask vapor deposition method of one embodiment of the present invention.
FIG. 4 is a cross-sectional side view showing the principal part configuration in the mask vapor deposition equipment of one embodiment of the present invention.
FIG. 5 is a plane view showing a target for vapor deposition in the mask vapor deposition method of one embodiment of the present invention.
FIG. 6 is a flow chart of the mask vapor deposition method of one embodiment of the present invention.
FIG. 7 is a flow chart for describing the method of manufacturing the organic EL device of one embodiment of the present invention.
FIG. 8 is a view showing an electronic apparatus having the organic EL device of the present invention.

### [Description of the Preferred Embodiment]

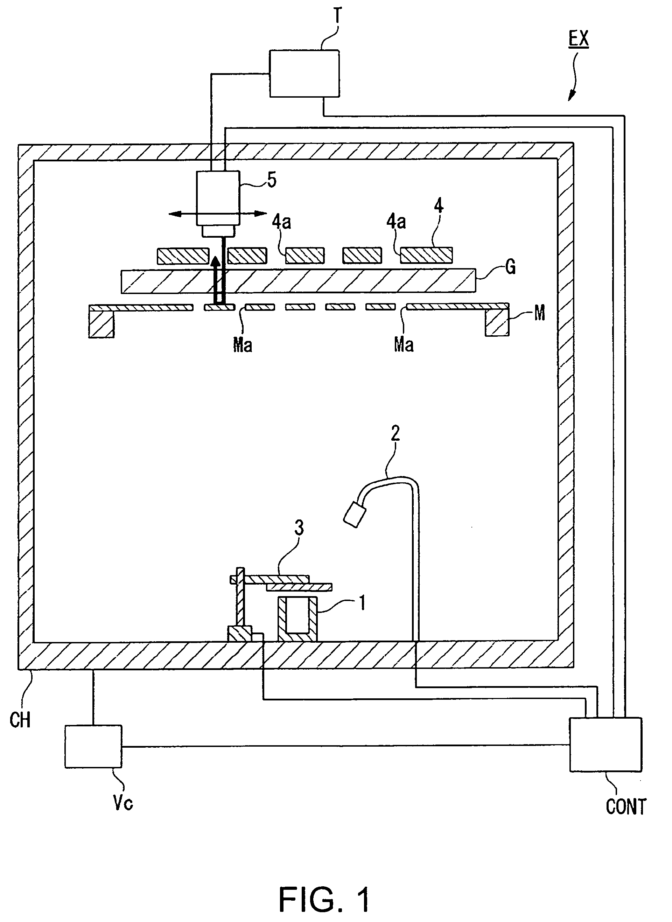

Hereinafter, a thin film formation method, thin film formation equipment, a method of manufacturing an organic electroluminescence device, an organic electroluminescence device, and an electronic apparatus of the present invention will be described with reference to FIG. 1 through FIG. 8. In addition, in the following description, a mask vapor deposition method and a mask vapor deposition equipment will be described as one form of the thin film formation method and the thin film formation equipment. Moreover, the following embodiments do not limit the present invention and can be changed arbitrarily within the technical scope of the present invention. Moreover, in each view, in order to make each layer and each member to a recognizable level of size on the drawings, the scale is changed for each layer and each member.

### (First embodiment of the mask vapor deposition equipment)

FIG. 1 is the cross-sectional side view showing the outline structure of the mask vapor deposition equipment (thin film formation equipment) of the present invention. As shown in FIG. 1, a mask vapor deposition equipment EX is provided with a vapor deposition source 1 (material source, thin film formation means), a film-thickness sensor 2, and a shutter (thin film formation means) 3 near the lower part in a chamber CH, and is provided with a vapor deposition mask M, a substrate G targeted for the vapor deposition, a sheet magnet (substrate contacting means) 4, and a laser displacement gauge (gap measurement means) 5 near the upper part in the chamber CH, and is provided with an exhaust means Vc, a displacement device (displacement means) T, and a control device (control means) CONT on the outside of the chamber CH.

Next, each constituent part will be described. The chamber CH is a container strong enough to withstand the pressure, even if the inside is vacuumized. Moreover, in the chamber CH there are provided valves or the like (not shown), and in these junction faces there are provided seal members, such as an O-ring, to keep the inside in an airtight vacuum condition. The vapor deposition source 1 has a predetermined material for vapor depositing to the substrate G, and the predetermined material can be vaporized with a heater or the like (not shown). The film-thickness sensor 2 has a crystal oscillator to control strictly the speed (vapor deposition rate) of the vapor deposition material which the vapor deposition source 1 is generating. The thickness of film that vapor-deposits in the substrate G is controlled by the film-thickness sensor 2. A shutter 3 shields between the vapor deposition source 1 and the substrate G, and un-shields therebetween. The shutter 3 operates to shield right above the vapor deposition source 1, and completes or stops the vapor deposition, when the film thickness controlled by the film-thickness sensor 2 reaches a predetermined value. The mask M has a plurality of openings Ma, which allow only the vapor deposition material passing through the Ma to adhere to the substrate G. Accordingly, the vapor deposition material in a predetermined pattern can be formed in the substrate G by forming the openings Ma in a predetermined pattern. For example, a pixel pattern of the vapor deposition material can be formed in the substrate G by the vapor deposition, by forming the openings Ma according to the pixel pattern of the organic EL device. Moreover, as for the mask M material, magnetic material which can be attracted with a magnet or the like, or non-magnetic material, such as silicone material where a mask can be formed by crystal anisotropic etching, is employed. The mask M according to the present embodiment is made of magnetic material which can be attracted by the sheet magnet 4. The substrate G is the target for the vapor deposition and is arranged facing to the vapor deposition source 1 through the mask M. As for the material of the substrate G, for example, a transparent substrate, such as a glass substrate, or non-transparent material, such as metal material or resin material, is employed. Moreover, as for the glass substrate material, silica glass or borosilicate glass is employed. The sheet magnet 4 functions as the substrate contacting means of the present invention, and in the present embodiment, in case that the mask M is a metal mask or the like, is used in order to attract the metal mask to the substrate G. Then, the sheet magnet 4 is provided in the backside, seen from the vapor deposition source 1 side, of the substrate G, i.e., in the non-formation face side of the vapor deposition material. Furthermore, in the sheet magnet 4, there are provided openings 4a from place to place, allowing the laser beam of the displacement gauge 5 to pass. The laser displacement gauge 5 functions as a gap measurement means of the present invention, and measures the gap between the mask M and the substrate G using the laser beam. Then, the laser displacement gauge 5 is provided in the backside, seen from the vapor deposition source 1 side, of the substrate G, i.e., in the non-formation face side of the vapor deposition material. An exhaust means Vc comprises a vacuum pump and a pressure adjustment valve to keep the pressure inside the chamber CH as desired according to the measurement value of a vacuum meter (not shown) that is provided in the chamber CH. A displacement device T functions as a displacement means of the present invention, and displaces the laser displacement gauge 5 in the plane direction on the sheet magnet 4 face (on the substrate G face). Thereby, the laser displacement gauge 5 can measure the gap between the mask M and the substrate G in a predetermined position inside the plane. A control device CONT functions as a control means of the present invention, and centrally controls each constituent part of the vapor deposition source 1, the film-thickness sensor 2, the shutter 3, the laser displacement gauge 5, the exhaust means Vc, and the displacement device T. Then, the control device CONT can also operate each constituent part according to a predetermined computer program. Moreover, provision is made to judge from the measurement result of the laser displacement gauge 5 whether the gap is a predetermined value or less. Furthermore, provision is made to be able to adjust various kinds of thin film formation conditions, such as carrying out open/close operations of the shutter 3, supplying electric power to the heater of the vapor deposition source 1, and adjusting the pressure inside the chamber CH according to such measurement result and judgment result. In addition, in the mask vapor deposition equipment EX, in order to improve the film-thickness distribution of the vapor deposition, a rotation mechanism for rotating the substrate G and the vapor deposition mask M while being fixed together may be provided, as shown in FIG. 1.

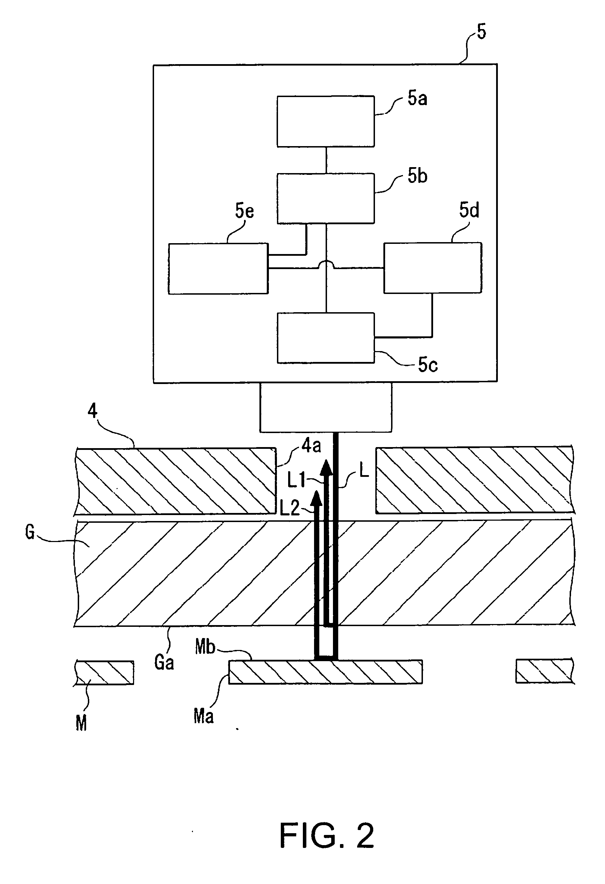

Next, with reference to FIG. 2, the configuration and the operation of the laser displacement gauge 5 will be described. The laser displacement gauge 5 comprises a light source portion 5a, a mirror portion 5b, a lens portion 5c, a lens drive portion 5d, and a light-receiving portion 5e, as its main constituent parts. In such a configuration, the laser beam emitted at the light source portion 5a will irradiate a measured portion through the mirror portion 5b having a half mirror, and through the lens portion 5c which is up/down-vibrating by the lens drive portion 5d. Here, by up/down-vibrating the lens portion 5c, the laser beam focal position is scanned in the irradiation direction of the laser beam. Then, the laser beam reflected only by the measured portion, where the laser beam focuses, is received by the light-receiving portion 5e through the half mirror of the mirror portion 5b. Thus, because the laser beam reflected only by the measured portion is large in intensity as compared with the laser beam reflected by the other portions, the light-receiving portion 5e can detect the position of the measured portion as the peak value of the intensity of the laser beam.

Accordingly, as shown in FIG. 2, a laser beam L, which the light source portion 5a irradiates, scans the measured face. Then, the focus of the laser beam L agrees with the position of a vapor deposition formation face Ga of the substrate G, and thereby a reflected light L1 occurs, and the reflected light L1 is detected by the light-receiving portion 5e as the peak value. Moreover, the focus of the laser beam L agrees with the position of a contact face Mb of the mask M, and thereby a reflected light L2 occurs, and the reflected light L2 is detected by the light-receiving portion 5e as the peak value. Then, the distance of the vapor deposition formation face Ga and the contact face Mb, i.e., the gap between the mask M and the substrate G, can be measured by calculating the space of the peak values obtained from the reflected light L1 and the reflected light L2. As for such a laser displacement gauge 5, it is preferable to employ a commercially available one. For example, LT-8010, LT-8110 and LT-9500 of KEYENCE CORP. are suitable. Because this measuring instrument has a very compact body, it is convenient to arrange inside the narrow chamber CH.

### (First embodiment of mask vapor deposition method)

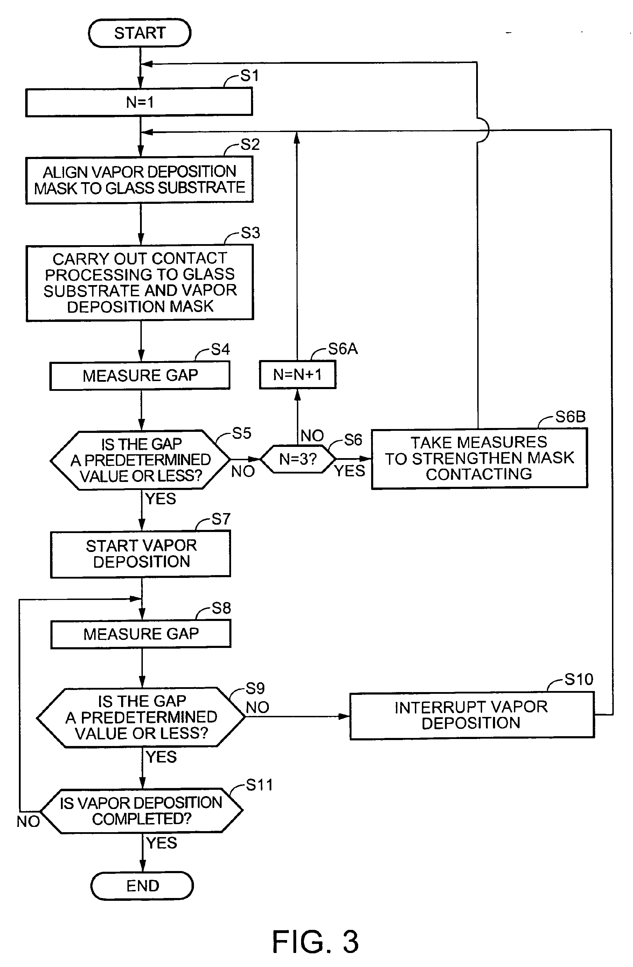

Next, a first embodiment of the mask vapor deposition method will be described with reference to a flow chart of FIG. 3. Moreover, in the mask vapor deposition method, a case where a pixel pattern is formed in the substrate G using the above described mask vapor deposition equipment EX will be described.

First of all, in order to reset the number of times of the gap measurement of the mask M and the substrate G, the number of times of the measurement N=1 is inputted (Step S1). Here, the number of times of the gap measurement is stored in the control device CONT.

Next, position alignment of the mask M and the substrate G is carried out (Step S2). In the step S2, it is carried out so that the opening Ma of the mask M may agree to a predetermined pattern provided in the substrate G, by operating a transport mechanism and a positioning mechanism (not shown).

Next, the substrate contacting process to contact the mask M and the substrate G is carried out (Step S3). In step S3, by having the mask M and the sheet magnet 4 come close as to sandwich the substrate G, an attraction force (magnetic force) occurs between the both, and the mask M is contacted to the vapor deposition formation face Ga of the substrate G.

Next, the gap measurement process to measure the gap between the mask M and the substrate G is carried out (Step S4). The step S4 is carried out using the above described laser displacement gauge 5. Accordingly, the laser beam L is irradiated to the vapor deposition formation face Ga and the contact face Mb, and by measuring the intensity of reflected lights L1 and L2 that are reflected, the gap between the vapor deposition formation face Ga and the contact face Mb is measured. Moreover, in the step S4, the measurement is carried out, while the displacement device T displaces the laser displacement gauge 5 back and forth, and right and left.

Next, whether the gap between the vapor deposition formation face Ga and the contact face Mb is smaller or larger than a predetermined value is judged (Step S5). The step S5 is carried out by the control device CONT. In the control device CONT, a predetermined value is stored in advance, and the predetermined value is compared with the measured gap value. Thereby, if the gap is larger than the predetermined value (in case of No), it judges that the vapor deposition cannot be carried out, and moves to Step S6. Moreover, if the gap is smaller than the predetermined value (in case of Yes), it judges that the vapor deposition can be carried out, and moves to Step S7.

In Step S6, whether the number of times of the gap measurement meets 3 or not is judged in the control device CONT. In the control device CONT, a predetermined value of the number of times of the gap measurement is stored in advance, and the predetermined value is compared with the number of times of the gap measurement. Thereby, if the number of times of the gap measurement is smaller than 3 (in case of No), it moves to step S6A. Moreover, if the number of times of the gap measurement is 3 (in case of Yes), it moves to step S6B.

In step S6A, after adding 1 to the value of the number of times N of the gap measurement, it returns to Step S2 and the alignment adjustment of the mask M and the substrate G is carried out again. Moreover, in step S6B, measures for strengthening the contact force of the mask M and the substrate G are taken. For example, measures of exchanging the existing sheet magnet 4 and installing a sheet magnet with a strong magnetic force are taken. After going through Step 6SB, it returns to Step S1, and the number of times of the measurement N=1 is inputted again, and various kinds of operations will be carried out based on the operation flow from the above described Step 1 through Step 6.

In Step S7, the thin film formation process to vapor-deposit is carried out. Accordingly, the vapor deposition material of the vapor deposition source 1 is vaporized, the vapor deposition material travels towards the substrate G, and the vapor deposition material enters only the exposed portions of the substrate G corresponding to the openings Ma of the mask M. Thereby, the vapor deposition material is vapor-deposited to the substrate G corresponding to the pattern of the openings Ma, and thin film is formed. In addition, the film thickness of the thin film is strictly controlled by the film-thickness sensor 2.

Next, the gap measurement process to measure the gap between the mask M and the substrate G is carried out while the vapor deposition is being carried out (Step S8). The step S8 is carried out in the same way as the previous Step 4. Accordingly, the laser beam L is irradiated to the vapor deposition formation face Ga and the contact face Mb, and by measuring the intensity of the reflected lights L1 and L2 that are reflected, the gap between the vapor deposition formation face Ga and the contact face Mb is measured. Moreover, in the step S8, the measurement is carried out, while the displacement device T displaces the laser displacement gauge 5 back and forth, and right and left.

Next, whether the gap between the vapor deposition formation face Ga and the contact face Mb is smaller or larger than a predetermined value is judged (Step S9). The step S9 is carried out by the control device CONT. In the control device CONT, a predetermined value is stored in advance, and the predetermined value is compared with the measured gap value. Thereby, if the gap is larger than the predetermined value (in case of No), it judges that the vapor deposition cannot be carried out, and moves to Step S10. Moreover, if the gap is smaller than the predetermined value (in case of Yes), it judges that the vapor deposition can be carried out, and moves to Step S11.

In Step 10, because the shutter 3 shields the upper part of the vapor deposition source 1, the vapor deposition processing is interrupted. Then, it returns to Step 2, the alignment of the mask M and the substrate G is carried out, and various kinds of operations will be carried out based on the operation flow from the above described step 2 through Step 9.

In Step 11, whether the vapor deposition is completed or not is judged. In this step 11, it is judged whether the film thickness, which the film-thickness sensor 2 measures, reaches the predetermined value or not. Thus, if the film thickness does not meet the predetermined value (in case of No), it returns to Step 8, and the vapor deposition will be carried out while measuring the gap. Moreover, if the film thickness meets the predetermined value (in case of Yes), because the vapor deposition will be completed, the shutter 3 will shield the upper part of the vapor deposition source 1, release the fixing of the vapor deposition mask M and the substrate G, and carry out only the substrate G.

As described above, in the mask vapor deposition equipment EX and the mask vapor deposition method, the substrate contacting process can be carried out to contact the mask M to the substrate G by using the sheet magnet 4. Furthermore, because the gap measurement process is carried out to measure the gap between the mask M and the substrate G, which are in the contact condition, by using the laser displacement gauge 5, lifting and peeling of the mask M due to the thermal expansion can be detected. Furthermore, because the vapor deposition is carried out according to the measurement result of the laser displacement gauge 5, the gap occurrence between the mask M and the substrate G can be prevented, and the thin film can be deposit-formed in the substrate G with the mask M and the substrate G being contacted. By going through such a series of processes, the thin film of a predetermined pattern corresponding to the opening Ma of the mask M can be deposit-formed to the substrate G with high precision and correctly. Accordingly, because the occurrence of defects such as that the material mixes in the other color pixels, which is the conventional problem, can be suppressed, the yield improvement can be attained.

Moreover, because the gap between the mask M and the substrate G is measured before carrying out the vapor deposition, the thin film can be deposit-formed while contacting the both suitably. Moreover, the thin film can be deposit-formed according to the measurement result of the gap, while measuring the gap between the mask M and the substrate G.

Moreover, because the vapor deposition is stopped according to the measurement result of the gap between the mask M and the substrate G, if the measurement result shows abnormalities (the gap has become large), the thin film will not be formed with the gap being large. Accordingly, the occurrence of defects such as that material mixes into the other color pixels can be prevented in advance.

Moreover, because the laser displacement gauge 5 is used as a means to measure the gap between the mask M and the substrate G, the changes of intensity of the laser beam L can be measured as the amount of gap between the mask M and the substrate G, therefore the gap can be measured easily. Moreover, the measurement is optically carried out not contacting to the measurement object, the measurement object will be neither damaged nor destroyed. Moreover, because the measurement can be carried out from non-formation face side of the thin film in the substrate G by measuring the gap between the mask M and the substrate G using the laser displacement gauge 5, the material of the vapor deposition source 1 does not adhere to the laser displacement gauge 5, therefore, the occurrence of measurement error caused by a fact that the material adheres to the laser displacement gauge 5 can be prevented. Accordingly, the gap between the mask M and the substrate G can be measured suitably.

In addition, as for the means to measure the gap between the mask M and the substrate G, changes of an electrostatic capacitance may be used. If doing this way, because an electrostatic capacitance can be measured as the amount of gap between the mask M and the substrate G, the gap can be measured easily. Moreover, because the measurement is electrically carried out not contacting to the measurement object, the measurement object will be neither damaged nor destroyed.

In addition, in this embodiment, a case where the mask M is used as the vapor deposition mask has been described, however it can also be used, for example, as a pattern deposition method in various kinds of vapor phase deposition methods, such as a sputtering mask and a CVD mask.

### (Modification of the first embodiment of the mask vapor deposition equipment)

Next, a modification of the first embodiment of the mask vapor deposition equipment will be described. In the first embodiment of above described mask vapor deposition equipment, the sheet magnet 4 is employed as the substrate contacting means, however, an electromagnet is employed in this modification. Because the magnetic force of an electromagnet can be adjusted with electric current supplied to the coil, the contact force of the mask M and the substrate G can be changed according to the gap size between the mask M and the substrate G. For example, if the gap becomes large, the contact force of the mask M and the substrate G will be increased by increasing the amount of electric current supplied to the coil. Thereby, the gap becomes small and it is possible to contact strongly. Moreover, as for the mask vapor deposition method having such an electromagnet, a method of increasing electric current supplied to the electromagnet can be employed as a measure of strengthening the mask contacting of step S6B in the flow chart shown in FIG. 3. If doing this way, the replacement work of the magnet can be unneeded.

### (Second embodiment of the mask vapor deposition equipment)

Next, a second embodiment of the mask vapor deposition equipment will be described. In the first embodiment and its modification of the mask vapor deposition equipment described above, the sheet magnet 4 and the electromagnet are employed as the substrate contacting means, however in this embodiment, the substrate and the mask are pressed and contacted by applying a load. In addition, in this embodiment, portions different from the mask vapor deposition equipment EX shown in FIG. 1 will be described. Moreover, the same numerals will be given to the same compositions as those of the above described embodiment to simplify the description.

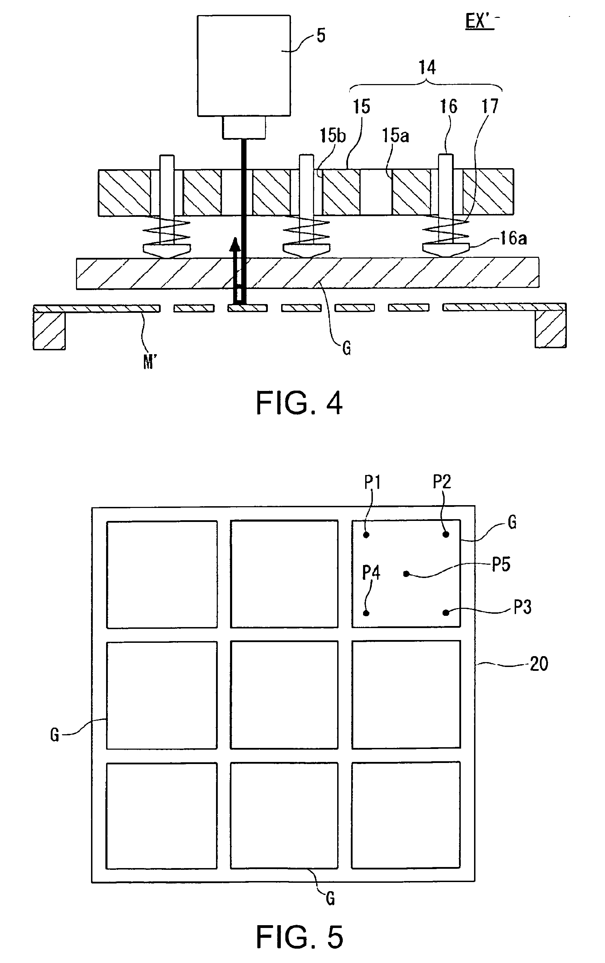

As shown in FIG. 4, mask vapor deposition equipment EX' is constituted comprising a load application portion 14 as the substrate contacting means, and a mask M' made of non-magnetic material. The load application portion 14 consists of a weight 15, a pin 16, and an elastic member 17. The weight 15 is provided with openings 15a and 15b, wherein the opening 15a is the region through which the laser beam of the laser displacement gauge 5 passes, and the opening 15b is the region through which the pin 16 fits in. The pin 16 is arranged as to fit in the penetration hole 15b, and the substrate G and the contact portion 16a are provided at the tip of the pin 16. The contact portion 16a is made of resin material, such as rubber, as not to damage the substrate G at the time of contacting to the substrate G. The elastic member 17 is the member having well-known elasticity, such as rubber and a spring, and is provided between the weight 15 and the pin 16 to alleviate contact of the contact portion 16a and the substrate G.

Thus, because the mask vapor deposition equipment EX' is constituted having the load application portion 14, the substrate G and the mask M can be contacted securely in the same manner as the above described embodiment. Furthermore, because it is possible to contact with the load of the weight 15, it is not necessary to contact with a magnetic force. Accordingly, the mask M' made of non-magnetic material can be used.

In addition, in the first and the second embodiments of the above-described mask vapor deposition equipment, as a means to contact the mask and the substrate G, the one using a magnetic force and the one using a load have been described, however, the present invention does not limit these. For example, the substrate G and the mask M may be contacted with an electrostatic force. Contacting the mask M and the substrate G with the electrostatic force is carried out by applying potentials of different polarity, plus (+) and (-), to each of the mask M and the substrate G. If doing this way, the both can be contacted using the electrostatic force that occurs between the mask M and the substrate G. In the method using such electrostatic force, it is preferable to have a structure where the substrate surface and the mask surface are charged easily.

### (Second embodiment of the mask vapor deposition method)

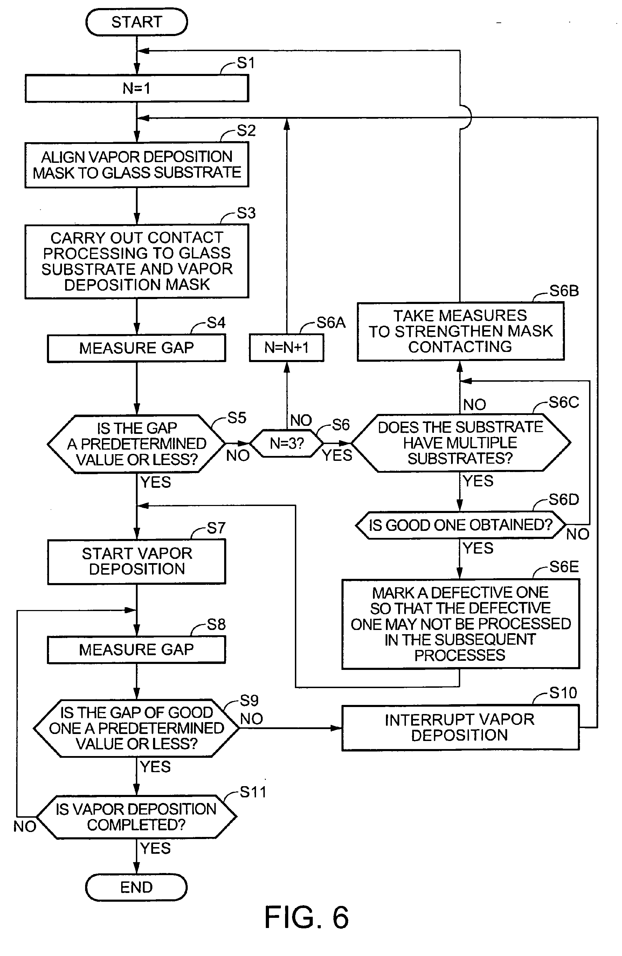

Next, a second embodiment of the mask vapor deposition method will be described. FIG. 5 is a plane view of a vapor deposition target which is mask vapor-deposited by the second embodiment of the mask vapor deposition method, and FIG. 6 is the flow chart of the mask vapor deposition method. In addition, in this mask vapor deposition method, the mask vapor deposition equipment EX described above is used. Moreover, in this embodiment, portions different from the flow chart shown in FIG. 3 will be described, and the same numerals will be given to the same processes as those of FIG. 3 to simplify the description.

The vapor deposition target of this embodiment is a mother substrate 20 consisted of a plurality of substrates G as shown in FIG. 5. Then, in the mask vapor deposition method of this embodiment, the mother substrate 20 is arranged inside the mask vapor deposition equipment EX described above to carry out the vapor deposition. Furthermore, the flow chart of the mask vapor deposition method of this embodiment is mainly the same as the mask vapor deposition method (FIG. 3) described above, however only Step S4, Step S5 and Step S6 are different.

In Step S4, the gap between the mask M and the substrate G is measured in a predetermined position inside the substrate G plane. The predetermined position includes measuring points Plthrough P4 near the comer portion of the substrate G, and a measuring point P5 in the center portion thereof. Furthermore, in Step S5, all the measuring points Plthrough P5 of the substrate G in the mother substrate 20 are measured. Here, the measuring points Plthrough P5 are regions where the gap between the mask M and the substrate G easily occurs, and the measurement of the portions, where the gap easily occurs, can be carried out by measuring the measuring points P1through P5. In addition, in order to measure each measuring point, the displacement device T drives and thereby displaces the laser displacement gauge 5 as desired, and the measurement is carried out.

Next, in Step S5, whether the gaps in the measuring points P1through P5 of each substrate G are smaller than a predetermined value or larger is judged (Step S5). This step S5 is carried out by the control device CONT. In the control device CONT, a predetermined value is stored in advance, and the predetermined value is compared with the measured gap value. Thereby, if the gap is larger than the predetermined value (in case of No), it judges that the vapor deposition cannot be carried out, and moves to Step S6. Moreover, if the gap is smaller than the predetermined value (in case of Yes), it judges that the vapor deposition can be carried out, and moves to Step S7.

Next, in Step S6, whether the number of times of the gap measurement meets 3 or not is judged in the control device CONT. In the control device CONT, a predetermined value of the number of times of the gap measurement is stored in advance, and the predetermined value is compared with the number of times of the gap measurement. Thereby, if the number of times of the gap measurement is smaller than 3 (in case of No), it moves to step S6A. Moreover, if the number of times of the gap measurement is 3 (if it is Yes), it moves to step S6C. In step S6A, because the same processing as that of the embodiment described above will be carried out, the description thereof is omitted.

Moreover, in step S6C, it is judged whether the substrate G has multiple substrates or not. Thus, if the substrate G does not have multiple substrates (in case of No), it moves to step S6B, and measures for strengthening the contact force of the mask M and the substrate G will be taken in the same way as the above described embodiment. Moreover, if the substrate G has multiple substrates (if it is Yes), it moves to step 6D.

In step S6D, it judges whether a good substrate can be obtained or not among 9 substrates G cited as an example of the multiple substrates, as shown in FIG. 5. Thus, if a good one cannot be obtained (in case of No), it moves to step S6B, and the measures for strengthening the contact force of the mask M and the substrate G will be taken in the same way as the above described embodiment. Moreover, if a good one can be obtained (if it is Yes), it moves to step S6E.

In Step S6E, a defective substrate is marked so that the marked substrate may not be processed in the subsequent processes. After going through this Step S6E, it moves to Step S7 and the same processing as that of the above described embodiment is carried out.

As described above, in this embodiment, because at least the gap at one point among the measuring points P1through P4 near the comer portion of the substrate G or the measuring point P5 in the center portion is measured, the gap at portions where the gap easily occurs can be measured. Moreover, provision is made not to process, in the processes after the vapor deposition, the substrate judged as defective among the plurality of substrates G, therefore, only good substrate G can be manufactured in the processes after the vapor deposition process.

### (Method of manufacturing organic EL device)

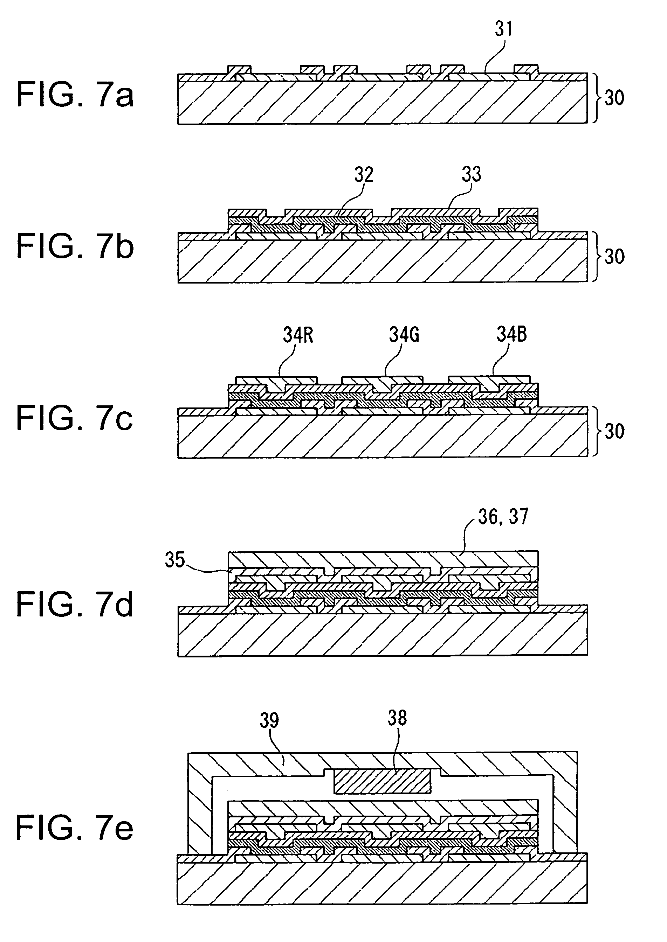

Next, a method of manufacturing an active type full color organic EL device by using the above-described mask vapor deposition equipment and mask vapor deposition method will be described with reference to FIG. 7. FIG. 7 is the explanatory diagram of the method of manufacturing the organic EL device using the present invention.

First of all, a low-temperature polysilicon TFT substrate 30 is prepared, and the surface of ITO 31 is washed using UV and ozone, and the work function of the ITO is increased to 4.5eV through 5.2eV (refer to FIG. 7a).

Next, after having deposited copper phthalocyanine (CuPc) of a hole injection material 32, in 10 nm, and 4, 4'-bis-[N-(1-naphthyl)-N-phenylamino] biphenyl (NPB) of a hole transportation material 33, in 60 nm, while shielding with a vapor deposition mask so that the vapor deposition material may not adhere to portions which do not contribute to the luminescence portion, the vapor deposition mask will be taken away (refer to FIG. 7b).

Next, the low-temperature polysilicon TFT substrate 30 is arranged inside the above described mask vapor deposition equipment EX, and alignment is carried out correctly so that the opening Ma of the vapor deposition mask M may agree with the position of a green luminescence pixel by using the high definition vapor deposition mask M where only pixel portions which emit green light are opened, and the substrate 30 is placed softly on the vapor deposition mask M.

Next, the sheet-form rubber magnet 4 is placed softly on the substrate 30, and the gap between the vapor deposition mask M and the substrate 30 will be eliminated. Furthermore, the gap between the metal mask M and the substrate 30 is measured with the laser displacement gauge 5 through the opening 4a formed in the sheet magnet 4, and if the gap is a predetermined size or less (for example, 15 µm or less), vapor deposition will be started. If there is a portion where the gap is the predetermined size or more, re-alignment will be carried out once again, the sheet magnet is placed softly, the measurement is carried out again, and the vapor deposition will be carried out after confirming that there is no space between the vapor deposition mask M and the substrate 30.

In this condition, a green luminescence layer 34G is formed by co-vapor-depositing a host material of green luminescence material; tris (8-quinolinolato - N1, 08)-aluminum (Alq), and a dope material; N, N-dimethyl quinacridon (DMQA) in 30 nm film thickness at the vapor deposition speed ratio of 100:1. Also in the course of this co-vapor-deposition, a fact that the gap is the predetermined size or less is confirmed by monitoring the gap measurement. If the gap becomes the predetermined size or more, the vapor deposition is interrupted immediately, the vapor deposition mask M is removed to carry out re-alignment, the sheet magnet 4 is placed softly, the measurement is carried out again, and the vapor deposition will be resumed after confirming that there is no space between the vapor deposition mask M and the substrate 30.

Furthermore, alignment is correctly carried out so that the opening Ma of the vapor deposition mask M may agree with the position of a red luminescence pixel by using the precise and high definition vapor deposition mask M where only pixel portions which emit red light are opened, and the substrate 30 is placed softly on the mask M. Next, the sheet-form rubber magnet 4 is placed softly on the substrate 30, and the gap between the vapor deposition mask M and the substrate 30 will be eliminated.

Furthermore, the gap between the metal mask M and the substrate 30 is measured with the laser displacement gauge 5 through the opening 4a formed in the sheet magnet 4, and if the gap is the predetermined size or less, the vapor deposition will be started. In this condition, a red luminescence layer 34R is formed by co-vapor-depositing a host material of red luminescence material; tris (8-quinolinolato - N1, 08) - aluminum (Alq), a dope material; rubrene, and a dope material; DCJTB in 40 nm film thickness at the vapor deposition speed ratio of 100:5:1. Of course, at the time of the vapor deposition, monitoring of the gap is surely carried out in the same way as the case of green. Finally, alignment is carried out correctly so that the opening Ma of the vapor deposition mask M may agree with the position of a blue luminescence pixel by using the precise and high definition vapor deposition mask M where only pixel portions which emit blue light are opened, and the substrate 30 is placed softly on the vapor deposition mask M.

Next, the sheet-form rubber magnet is placed softly on the substrate, and the gap between the vapor deposition mask M and the substrate will be eliminated. Furthermore, the gap between the metal mask M and the substrate 30 is measured with the gap measurement device through the opening 4a formed in the sheet magnet 4 in the same way as at the time of the vapor deposition of green and red luminescence material, and vapor deposition will be started if the gap is a predetermined size or less. In this condition, a blue luminescence layer 34B is formed by co-vapor-depositing a host material of blue luminescence material; DPVBi, and a dope material; BczVBi in 20 nm film thickness at the vapor deposition speed ratio of 100:1. At this time, monitoring of the gap is surely carried out at the time of the vapor deposition in the same way. Thus, if taking away the mask, an organic EL device with the luminescence layers being coated correctly and separately is formed (refer to FIG. 7c).

Next, an electron transporting layer 35 is formed by depositing tris (8-quinolinolato - N1, 08) - aluminum (Alq) of an electron transporting material, in 30 nm, while shielding with the vapor deposition mask so that the vapor deposition material may not adhere to portions which do not contribute to the luminescence portion. Furthermore, an electron injection layer 36 is formed by depositing lithium fluorides of an electron injection material, in 1 nm. Furthermore, a cathode 37 is formed by vapor-depositing Al in 200 nm (Refer to FIG. 7d).

In order to protect the organic EL device, which is formed in this manner, from humidity and oxygen, desiccant 38 is put into a sealing glass 39 in which a cavity for putting in the desiccant 38 is formed, and adhesive is applied to the periphery to stick to the low-temperature polysilicon TFT substrate (refer to FIG. 7e), and thereby the panel manufacturing process will be completed.

It is confirmed that the organic electroluminescence device manufactured by the method of manufacturing the organic EL device according to the present invention has no mixing of luminescence colors, is very clear, and can be manufactured with a very high yield, because there is no gap of the vapor deposition mask.

As described above, there are no defects, such as smear of luminescence colors, which are caused by the material mixing into other color pixels due to mask lifting, and thus an organic EL device can be manufactured with a very high yield. In addition, the present invention is not limited to the organic EL device, but can be also used for manufacturing of color filters for liquid crystal, and for manufacturing of an organic transistor or the like by a pigment deposition method.

### (Electronic apparatus)

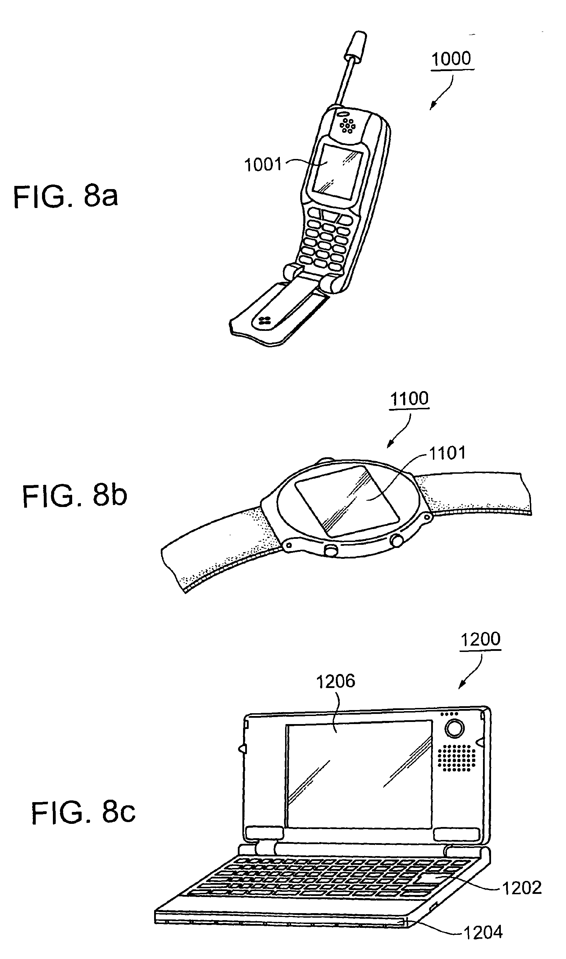

Next, examples of electronic apparatus having the organic EL device of the above described embodiments will be described. FIG. 8a is a perspective view showing an example of a cellular phone. In FIG. 8a, a numeral 1000 refers to a cellular phone body, and a numeral 1001 refers to a display portion using the above described organic EL device.

FIG. 8b is a perspective view showing an example of a wristwatch type electronic apparatus. In FIG. 8b, a numeral 1100 refers to a clock body, and a numeral 1101 refers to a display portion using the above described organic EL device. FIG. 8c is the perspective view showing an example of a portable type information processing apparatus, such as a word processor and a personal computer. In FIG. 8c, a numeral 1200 refers to an information processing apparatus, a numeral 1202 refers to an input portion, such as a keyboard, a numeral 1204 refers to an information processing apparatus body, and a numeral 1206 refers to a display portion using the above described organic EL device. The electronic apparatus shown in FIG. 8a through 8c are provided with the organic EL apparatus of the above described embodiments, therefore, will be an electronic apparatus having pixels without color mixing and provided with a display portion which allows clear picture displaying.

In addition, the electronic apparatus is not limited to the cellular phone and the like, but the present invention can be applicable to various electronic apparatus. For example, the present invention can be applicable to a notebook type computer, an LCD projector, a personal computer (PC) dealing with multimedia, and an engineering workstation (EWS), a pager, a word processor, a television, a view finder type or a monitor direct-vision type video tape recorder, an electronic notebook, an electronic desk-top calculator, a car navigation system, a POS terminal, and an electronic apparatus having a touch panel, and the like.

### [Reference Numerals]

1: Vapor deposition source (material source, thin film formation means)
3: Shutter (thin film formation means)
4: Sheet magnet (substrate contacting means)
5: Laser displacement gauge (gap measurement means)
14: Load application portion G (substrate contacting means)
30: Substrate
M: Mask
L: Laser beam
T: Displacement device (displacement means)
EX, EX': Mask vapor deposition equipment (thin film formation equipment)
CONT: Control device (control means)

## Claims

1. A thin film formation method that arranges a mask between a substrate and a material source and forms material of the material source as thin film in the substrate, comprising:
a substrate contacting process to contact the mask and the substrate;
a gap measurement process to measure a gap between the mask and the substrate; and
a thin film formation process to form the thin film according to a measurement result in the gap measurement process.

2. The thin film formation method according to claim 1, wherein the gap measurement process is carried out before the thin film formation process.

3. The thin film formation method according to claim 1, wherein the gap measurement process is carried out simultaneously with the thin film formation process.

4. The thin film formation method according to any one of claim 1 through claim 3, wherein the thin film formation process is stopped according to a measurement result of the gap measurement process.

5. The thin film formation method according to any one of claim 1 through claim 4, wherein the contact force in the substrate contacting process is changed according to a measurement result of the gap measurement process.

6. The thin film formation method according to any one of claim 1 through claim 5, wherein the substrate contacting process contacts the substrate and the mask with a magnetic force.

7. The thin film formation method according to any one of claim 1 through claim 5, wherein the substrate contacting process contacts the substrate to the mask by pressing.

8. The thin film formation method according to any one of claim 1 through claim 5, wherein the substrate contacting process contacts the substrate and the mask with an electrostatic force.

9. The thin film formation method according to any one of claim 1 through claim 5, wherein the gap measurement process uses a laser beam.

10. The thin film formation method according to any one of claim 1 through claim 5, wherein the gap measurement process is carried out by measuring an electrostatic capacitance.

11. The thin film formation method according to any one of claim 1 through claim 10, wherein the gap measurement process is carried out from non-formation face side of the thin film in the substrate.

12. The thin film formation method according to any one of claim 1 through claim 11, wherein the gap measurement process measures the gap at least either near the comer portion or in the center portion within a main face of the substrate.

13. Thin film formation equipment that arranges a mask between a substrate and a material source and forms material of the material source as thin film in the substrate, comprising:
a substrate contacting means to contact the mask and the substrate;
a gap measurement means to measure a gap between the mask and the substrate; and
a thin film formation means to form thin film in the substrate.

14. The thin film formation equipment according to claim 13, further comprising a displacement means to displace the gap measurement means in the direction parallel to the substrate.

15. The thin film formation equipment according to claim 14, further comprising a control means to control at least any one of the substrate contacting means, the gap measurement means, the thin film formation means, and the displacement means.

16. A method of manufacturing an organic electroluminescence device that is formed by adhering each of a plurality of different material to a substrate in a predetermined pattern, wherein any one of the thin film formation methods according to claim 1 through claim 12 is used.

17. An organic electroluminescence device using the manufacturing method according to claim 16.

18. An electronic apparatus having the organic electroluminescence device according to claim 17.
